# EUROPEAN PATENT APPLICATION

(11) **EP 2 418 739 A1**
(43) Date of publication of application: **15.02.2012**
(21) Application number: 11176826.3
(22) Date of filing: 08.08.2011
(51) Int. Cl.: H01R 4/58

(54) **Electrical connection structure and light emitting diode module, fabric circuits, and signal textile having the same**

(30) Priority: 09.08.2010 TW 099126473
(71) Applicant: King's Metal Fiber Technologies Co., Ltd., Taipei City (TW)
(72) Inventor: Huang, Hong Hsu, Taipei City (TW); Fang, Chih-Chang, Taipei City (TW)
(74) Representative: Schulz, Dirk

(57) **Abstract**

An electrical connection structure for use in an electronic component, a light emitting diode (LED) module, a fabric circuit and a signal textile having the same are provided. The electrical connection structure comprises a plurality of J-type leads which electrically connect to the electronic component and encircle two conductive lines. Thus, the electronic component can be firmly attached and electrically connected to the two conductive lines.

## Description

This application claims priority to Taiwan Patent Application No. 099126473 filed on August 9, 2010.

### CROSS-REFERENCES TO RELATED APPLICATIONS

Not applicable.

### BACKGROUND OF THE INVENTION

### Field of the Invention

The present invention relates to an electrical connection structure and an electronic unit with the same. In particular, the present invention relates to an electrical connection structure capable of firmly encircling two conductive wires as well as a light emitting diode (LED) module, a fabric circuit and a signal textile with the same.

### Descriptions of the Related Art

Over recent years, as innovations are continuously being made in conventional textile industries, advanced technologies have been introduced to develop high-value products; this trend has extended to the product application level. Furthermore, due to the rapid development of electronic industries, electronic components have been gradually applied to textiles. Light emitting diodes (LEDs), the most common application of such electronic components in textiles, have been incorporated in textiles so that the conventional textile can emit light for signaling purposes.

One of the conventional approaches to integrate an electronic component such as an LED into a textile is to encapsulate the electronic component to be integrated into the textile and then attach the electronic component to the textile by means of a supporting device. However, this approach adds to the manufacturing complexity and the cost, and if other electronic components are to be connected to the textile, the overall aesthetic appearance of the textile will be compromised. Therefore, the flexibility of incorporating electronic components into textiles is relatively limited. Another conventional approach is to dispose conductive contacts on a sheathed wire, connect electrodes of an LED to the conductive contacts so that the electrodes of the LED are electrically connected with the wire, and then sew the covered wire electrically connected with the LED to the textile. Both of the two approaches described above involve complex manufacturing steps, which is unfavorable for the automation of the manufacturing process.

Accordingly, an urgent need exists in the art to provide an electrical connection structure for an electronic component that can be used in textiles to simplify the manufacturing process and improve the aesthetic aspect and usefulness of clothing.

### SUMMARY OF THE INVENTION

An objective of the present invention is to provide an electrical connection structure for an electronic component. The electrical connection structure comprises a plurality of J-type leads electrically connected to the electronic component. Each of the J-type leads is a metal lead comprising a connecting end and a free end. The connecting end connects to the electronic component, and the free end encircles conductive wires by a winding jig or further passes through and then encircles the conductive wire so that the electronic component can be firmly attached to and electrically connected to the two conductive wires. This is favorable for the automation of the production operations and can simplify the manufacturing process to lower the manufacturing cost.

Another objective of the present invention is to provide an LED module, which comprises an LED component and a plurality of J-type leads. Each of the J-type leads is electrically connected to the LED component, and encircles one of two conductive wires respectively so that the LED component is firmly attached to and electrically connected to the two conductive wires.

Yet a further objective of the present invention is to provide a fabric circuit. The fabric circuit comprises an LED module described above, a first conductive wire and a second conductive wire. The first conductive wire and the second conductive wire are disposed in parallel, and the LED module comprises a plurality of J-type leads encircling the first conductive wire and the second conductive wire respectively.

Yet a further objective of the present invention is to provide a signal textile. The signal textile comprises the following: a plurality of first conductive threads disposed in parallel; a plurality of second conductive threads disposed in parallel, wherein each of the first conductive threads is vertical to each of the second conductive threads; and at least one electronic unit. Each electronic unit comprises an electronic component and a plurality of J-type leads. Each of the J-type leads is electrically connected to the electronic component and encircles one of the first conductive threads and one of the second conductive threads respectively so that the electronic component is firmly attached to and electrically connected to one of the first conductive threads and one of the second conductive threads.

The detailed technology and preferred embodiments implemented for the subject invention are described in the following paragraphs accompanying the appended drawings for people skilled in this field to well appreciate the features of the claimed invention.

### BRIEF DESCRIPTION OF THE DRAWINGS

**FIGS. 1A** and **1B** are schematic cross-sectional views of an LED module according to the first embodiment of the present invention;
**FIGS. 2A** and **2B** are schematic top views of the LED module according to the first embodiment of the present invention shown in **FIGS. 1A** and **1B**;
**FIG. 3** is a schematic view of a fabric circuit according to the second embodiment of the present invention;
**FIG. 4A** shows positions where two J-type leads are disposed in the third embodiment of the present invention; and
**FIG. 4B** is a schematic view of a signal textile according to the third embodiment of the present invention.

### DESCRIPTION OF THE PREFERRED EMBODIMENT

In the following description, the present invention will be explained with reference to embodiments thereof. However, the description of these embodiments is only intended to illustrate the technical contents and effects of the present invention rather than to limit the present invention. It should be appreciated that in the following embodiments and the attached drawings, elements unrelated to the present invention are omitted from depiction; and dimensional and positional relationships among individual elements in the attached drawings are illustrated only for ease of understanding, but not to limit the actual scale and dimensions.

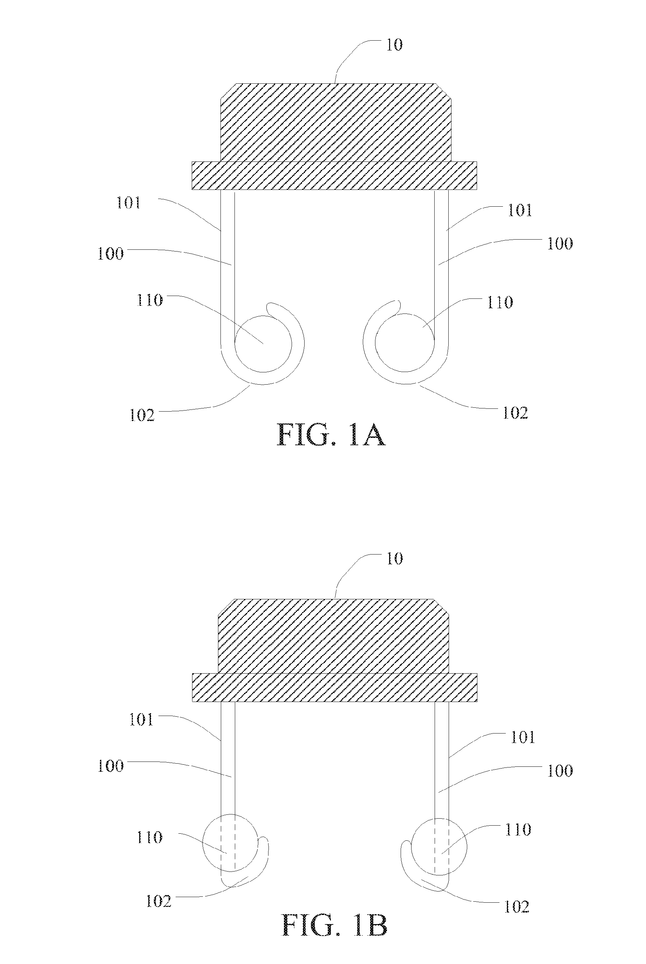

**FIG. 1A** and **FIG. 1B** illustrates a schematic view of an electronic unit according to the first embodiment of the present invention. The electronic unit comprises an electronic component 10 and an electrical connection structure **100** for connection with two parallel conductive wires 110. In this embodiment, the electronic component 10 is a surface mount device (SMD) which may be, for example, a light emitting diode (LED) of a top-view structure or a side-view structure, in which case the electronic unit 1 of the first embodiment shown in **FIG. 1A** and **FIG. 1B** is an LED module. Alternatively, as is well known by people skilled in the art, other devices may be used instead for the SMD depending on actual requirements, such as a surface mount resistor, a surface mount capacitor, a surface mount inductor, a surface mount switch, a surface mount sensor, a surface mount amplifier, a surface mount integrated circuit chip. The aforesaid illustrative description is only intended to illustrate the present invention, but not to limit the scope of the present invention.

One of the characteristics of the present invention lies in that the electrical connection structure of the electronic unit comprises a plurality of J-type leads, the number of which (e.g., two, three, four or more) may vary with the type of the electronic unit. As is well known by people skilled in the art, the J-type leads and the electronic unit may vary depending on actual requirements; therefore, the following embodiments of the present invention are only provided for the purpose of illustration, but not to limit the scope of the present invention.

In reference to the first embodiment of the present invention as shown in **FIG. 1A** and **FIG. 1B**, the electronic unit **1** comprises two J-type leads **100,** each of which is a metal lead electrically connected to the electronic component **10.** Specifically, each J-type lead **100** comprises a connecting end **101** and a free end **102.** The connecting end **101** connects to the electronic component **10,** while the free end **102** is of a J-type winding structure adapted to encircle and attach the two parallel conductive wires **110** so that the electronic component **10** is firmly attached to and electrically connected to the two conductive wires **110.**

**FIG. 1B** illustrates another form of connection between the two J-type leads **100** and the two parallel conductive wires **110** in this embodiment. Specifically, as shown in **FIG. 1B**, the free end **102** of each J-type lead **100** further passes through and then encircles each of the conductive wires **110** to encircle the conductive wire **110** more firmly while also electrically connecting to the conductive wire **110.**

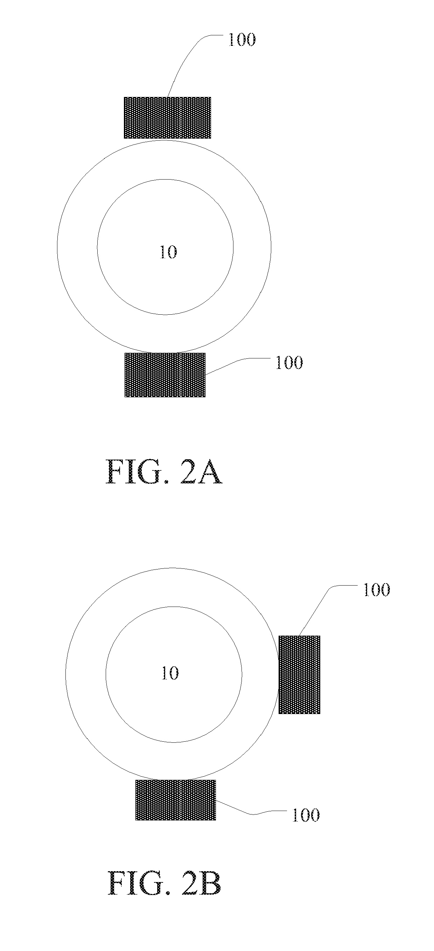

**FIG. 2A** and **FIG. 2B** illustrates a schematic top view of the electronic unit in the first embodiment shown in **FIG. 1A** and **FIG. 1****B.** It shall be appreciated that in the embodiment shown in **FIG. 2A** and **FIG. 2B****,** an LED is taken as an example of the electronic component **10,** and the electronic unit is an LED module. It shall be emphasized that the J-type leads **100** may be disposed with respect to the electronic component 10 of the LED module in different ways according to the different arrangements of the two conductive wires. For example, in case of the two conductive wires parallel with each other or two conductive wires perpendicular to each other, positions of the two leads in the electronic unit can be adjusted correspondingly to match with the arrangement of the two conductive wires. Specifically, in **FIG. 2A**, the two J-type leads **100** are disposed on two opposite sides of the electronic component **10** respectively, and in **FIG. 2B**, the two J-type leads **100** are disposed on two adjacent sides of the electronic component **10** respectively. However, the aforesaid arrangements of the lead positions are only illustrated to show that the electrical connection structure of the electronic unit of the present invention can be advantageously adjusted in its position, but not to limit the lead positions to what is shown in **FIG. 2A** and **FIG. 2B**. Other relative positions of the two leads may also be adopted depending on particular needs, for example, positions apart from each other by 60 degrees or by 120 degrees, and this will not be further described herein.

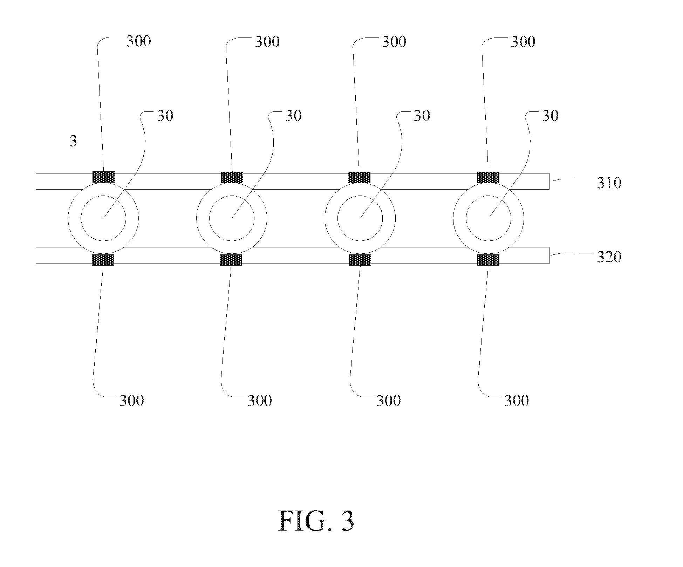

**FIG. 3** illustrates the schematic view of a fabric circuit **3** according to the second embodiment of the present invention. The fabric circuit **3** is a product in which the aforesaid electronic unit is used. Specifically, the fabric circuit **3** comprises at least one electronic unit **30,** a first conductive wire **310** and a second conductive wire **320.** The first conductive wire **310** and the second conductive wire **320** are disposed in parallel and are both made of a conductive metal such as nickel-plated copper, copper, silver, an alloy thereof, or some other metal. In this embodiment, the first conductive wire 310 and the second conductive wire 320 are both a naked metal wire. In other words, the two wires have no blanket.

On the other hand, the aforesaid electronic unit 30 may be the LED module described above or may be any other SMD As described in the aforesaid embodiment, two J-type leads 300 of each LED module 30 are disposed on two opposite sides of the LED module 30 respectively and encircle the first conductive wire 310 and the second conductive wire 320 respectively in this embodiment. When a positive voltage level and a negative voltage level are applied to the two conductive wires respectively, a plurality of LED modules of the fabric circuit 3 of this embodiment will emit light to form a light strip. Thus, the application scope of the conventional LEDs can be extended.

It shall be appreciated that because the electrical connection structure of the electronic unit in the present invention has specially designed J-type leads, each electronic unit in the fabric circuit 3 of the present invention can be attached to the two conductive wires by using the J-types leads to directly embrace the two conductive wires instead of using the conventional Surface Mount Technology (SMT). This can reduce the complexity in the manufacturing process. More specifically, before the electronic unit of the present invention is firmly attached to the conductive wires, the free end of each of the J-type leads is actually in the form of a straight line. A plurality of electronic units can be respectively loaded into an assembling line in sequence. The electronic units can be carried one by one by an appropriate carrier (not shown) to two conductive wires and connected across the two conductive wires; and then through a clamping action (similar to the clamping action of a stapler) of a winding jig; the leads of each electronic unit can be firmly attached to the conductive wires respectively by encircling the conductive wires. Thus, the fabric circuit of the present invention can be automatically manufactured by use of appropriate automatic manufacturing equipment to simplify the conventional manufacturing process which is complex and even semi-manual.

Additionally, it shall be particularly appreciated that when both the first conductive wire and the second conductive wire are further covered with an insulated material (e.g., para-aramid fibers, polyester fibers, cotton or other non-metal materials) to become conductive threads, the form of the electrical connection structure shown in **FIG. 1B** may be adopted for electrical connection between the conductive threads and the electronic units. In this case, an appropriate clamping jig is used to insert the free ends of the leads that are still in a straight line form directly through the first conductive thread and the second conductive thread, and then through an appropriate clamping action, the free ends are wound to firmly encircle the conductive threads respectively so that both the physical connection and electrical connection can be achieved between the conductive threads and the electronic units simultaneously.

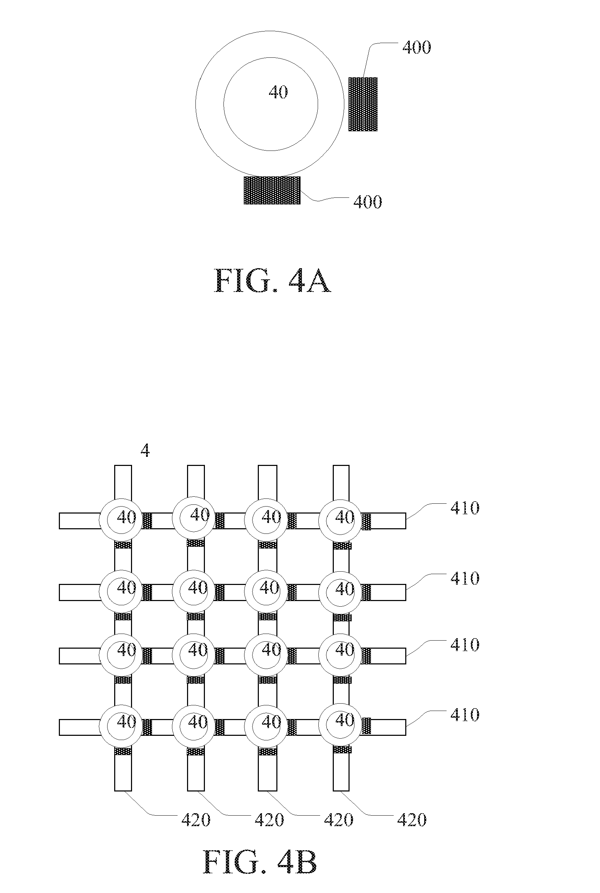

The third embodiment of the present invention is shown in **FIG. 4A** and **FIG. 4B**, which are schematic views illustrating a signal textile 4 and positions of two J-type leads of an electronic unit. The signal textile 4, which represents a further application of the fabric circuit of the second embodiment described above, comprises at least one electronic unit, a plurality of first conductive threads 410 and a plurality of second conductive threads 420. Identical to the aforesaid electronic units, the electronic unit also comprises an electronic component **40** and two J-type leads **400.** Each of the aforesaid first conductive wires and each of the aforesaid second conductive wires are covered with an insulated material to form the first conductive threads **410** and the second conductive threads **420** respectively. The first conductive threads **410** are disposed in parallel, and the second conductive threads **420** are also disposed in parallel. The first conductive threads **410** are vertically interlaced with the second conductive threads **420** to form a piece of fabric.

In this embodiment, each of the J-type leads **400** is electrically connected to the electronic component **40** and disposed on two adjacent sides of the electronic component respectively. Thus, at locations where the first conductive threads and the second conductive threads are overlapped in the piece of fabric, the J-type leads **400** can pass through and then encircle the first conductive threads **410** and the second conductive threads **420** that are vertically interlaced respectively so that the electronic components **40** are firmly attached to and electrically connected to the first conductive threads **410** and the second conductive threads **420.** In this case, a plurality of SMDs such as LEDs can be disposed in a matrix form on the piece of fabric formed by the first conductive threads **410** and the second conductive threads **420** to transmit signals such as marquee signals.

According to the above descriptions, the present invention provides an electrical connection structure which can be used in an SMD, a fabric circuit and a signal textile. By means of the electrical connection structure, at least one electronic component can be attached to the fabric circuit or the signal textile quickly. Because the present invention has advantages such as easy and cheap manufacturing, the disadvantages of prior art technologies can be overcome.

The above disclosure is related to the detailed technical contents and inventive features thereof. People skilled in this field may proceed with a variety of modifications and replacements based on the disclosures and suggestions of the invention as described without departing from the characteristics thereof. Nevertheless, although such modifications and replacements are not fully disclosed in the above descriptions, they have substantially been covered in the following claims as appended.

## Claims

1. An electrical connection structure for an electronic component, comprising:
a plurality of J-type leads, being electrically connected to the electronic component, wherein the J-type leads encircle two conductive wires respectively so that the electronic component is firmly attached to and electrically connected to the two conductive wires.

2. The electrical connection structure as claimed in claim 1, wherein the J-type leads are two J-type leads.

3. The electrical connection structure as claimed in claim 1 or claim 2, wherein each of the J-type leads is a metal lead comprising a connecting end and a free end, the connecting end connects to the electronic component, and the free end encircles each of the conductive wires by a winding jig.

4. The electrical connection structure as claimed in claim 2 or claim 3, wherein each of the two J-type leads further passes through and then encircles each of the conductive wires.

5. The electrical connection structure as claimed in any one of claims 2-4, wherein the two J-type leads are disposed on two opposite sides of the electronic component respectively.

6. The electrical connection structure as claimed in any one of claims 2-4, wherein the two J-type leads are disposed on two adjacent sides of the electronic component respectively.

7. The electrical connection structure as claimed in any one of claims 1-6, wherein the two conductive wires are disposed in parallel.

8. The electrical connection structure as claimed in any one of claims 1-7, further comprising:
a plurality of first conductive threads, each of the first conductive threads being disposed in parallel; and
a plurality of second conductive threads, each of the second conductive threads being disposed in parallel,
wherein each of the first conductive threads is vertical to each of the second conductive threads, one of the two conductive wires is one of the first conductive threads, and the other of the two conductive wires is one of the second conductive threads.

9. The electrical connection structure as claimed in claim 8, wherein two J-type leads further pass through one of the first conductive threads and one of the second conductive threads respectively and encircle each of the conductive threads.

10. The electrical connection structure as claimed in any one of claims 1-9, wherein the electronic component comprises at least one of an LED component, a resistor, a capacitor, a switch, a sensor, an amplifier, an integrated circuit chip and the combination thereof.
